# EUROPÄISCHE PATENTSCHRIFT

(11) **EP 1 199 829 B1**
(45) Veröffentlichungstag und Bekanntmachung des Hinweises auf die Patenterteilung: **01.02.2012**
(21) Anmeldenummer: 01124629.5
(22) Anmeldetag: 16.10.2001
(51) Int. Cl.: H04L 1/00

(54) **Verfahren zum Auswählen (puncturing) von Datenbits**
Method for puncturing data bits
Procédé pour le poinçonnage des bits de données

(30) Priorität: 17.10.2000 DE 10051243
(43) Veröffentlichungstag der Anmeldung: 24.04.2002
(73) Patentinhaber: ST-Ericsson SA, 1228 Plan-les-Ouates (CH)
(72) Erfinder: Tritthart, Arthur, Philips Corp. Intel. Prop. GmbH, 52064 Aachen (DE); Müller, Hans, Philips Corp. Intel. Property GmbH, 52064 Aachen (DE)
(74) Vertreter: Klunker . Schmitt-Nilson . Hirsch

(56) Entgegenhaltungen:
- WO-A-00/08767
- WO-A-97/50218
- US-A- 4 450 562
- US-A- 4 771 281

## Beschreibung

Die Erfindung betrifft ein Verfahren zum Auswählen (puncturing) von Datenbits aus einem Datenwort in einem Datenverarbeitungssystem, insbesondere einem Kommunikationssystem.

Solche Verfahren sind bekannt und dienen dazu, bestimmte Datenbits aus einem Datenwort auszuwählen und damit den Datenbitstrom auf die gewünschten Informationsbits zu reduzieren. Solche Verfahren kommen beispielsweise im Rahmen der Kanalcodierung bei einem mobilen Kommunikationssystem wie z. B. der mobilen Telefonie zum Einsatz.

Bei bekannten Verfahren erfolgt die Auswahl derart, dass pro Arbeitszyklus eines Arbeitsprozessors, der die Auswahl vornimmt, aus einem Datenwort jeweils nur ein Datenbit ausgewählt wird. Ein zweites Datenbit aus demselben Datenwort kann erst im nächsten Arbeitszyklus ausgewählt werden. Folglich sind bekannte puncturing-Verfahren sehr langsam, es dauert relativ lange, bis das sampling der relevanten Daten abgeschlossen ist. Entsprechend lang dauert es zwangsläufig dann auch, die gesampelten und komprimierten Daten weiterzuverarbeiten.

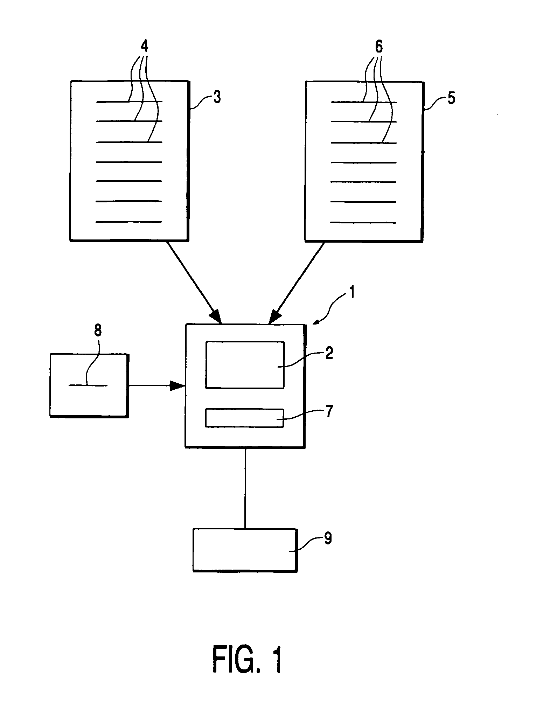

US 4,771,281 A betrifft eine Vorrichtung zum Auswählen von Datenbits, wobei m Datensignale von n verfügbaren Dateneingabebits ausgewählt werden. Wie insbesondere in Fig. 1 gezeigt, erhält eine Bitauswahleinheit Dateneingabebits von einem Datenwort, das in einem Eingangsregister gespeichert ist. Die Bitauswahleinheit erhält weiterhin Auswahl- und Steuersignale über eine Mehrzahl von Leitungen von einem Steuerbit-Auswahlregister. Die Ausgabe der Bitauswahleinheit wird von einem Ausgangsregister empfangen. Die Bitauswahleinheit leitet die ausgewählten Eingangsbits des Datenworts zu den niedrigwertigen Bits des Ausgangsworts, wie über die Steuersignale von dem Steuerbit-Auswahlregister bestimmt. Die höherwertigen Bits des Ausgabeworts werden mit logischen Nullen aufgefüllt.

Der Erfindung liegt das Problem zugrunde, ein Auswahl- oder puncturing-Verfahren anzugeben, das gegenüber bekannten Verfahren schneller und effizienter arbeitet.

Zur Lösung dieses Problems ist bei einem eingangs beschriebenen Verfahren vorgesehen, dass innerhalb eines Arbeitszyklus eines Arbeitsprozessors das oder die Datenbits des n Datenbit umfassenden Datenworts anhand eines n Auswahlbit umfassenden Auswahlbitregisters, dessen Auswahlbits angeben, ob ein Datenbit des Datenworts auszuwählen ist, ausgewählt werden.

Das erfindungsgemäße Verfahren nutzt zum Auswählen ein Auswahlbitregister, das quasi eine Auswahlmaske darstellt, und in das entsprechende Auswahlbits eingeschrieben sind, von denen jedes einem bestimmten Datenbit des zu bearbeitenden Datenworts zugeordnet ist. Das Datenwort und das Auswahlbitregister enthalten jeweils gleich viele Bits. Innerhalb eines Arbeitszyklus wählt der Arbeitsprozessor nun anhand des vorgegebenen Auswahlmusters diejenigen Datenbits aus dem Datenwort, die im Auswahlbitregister durch die entsprechenden Auswahlbits angegeben werden. Hierdurch ist es also möglich, innerhalb lediglich eines Arbeitszyklus eine beliebige Anzahl x ≤ n aus dem Datenwort auszuwählen. Es sind hier beliebige Auswahlschemata denkbar, die durch den Programmierer festgelegt werden und es zulassen, beliebige Informationen zu extrahieren. Da also innerhalb eines Arbeitszyklus ein komplettes Datenwort, beispielsweise ein 16-Bit-Wort unter Verwendung eines entsprechenden 16-Bit-Auswahlbitregisters bearbeitet wird, ist ein wesentlich schnelleres Sampeln der relevanten Datenbits aus einem Datenbitstrom möglich als beim bekannten Stand der Technik.

Die ausgewählten Datenbits werden zweckmäßigerweise zunächst in einen Zwischenspeicher geschrieben, bei dem es sich zweckmäßigerweise um einen Schieberegisterspeicher handelt. Es hat sich als zweckmäßig erwiesen, wenn der Zwischenspeicher als 31-Bit-Schieberegister ausgebildet ist, er kann aber auch größer sein.

Insbesondere im Hinblick auf die Weiterverarbeitung der gesampelten Datenbits ist es zweckmäßig, wenn die innerhalb eines Arbeitszyklus ausgewählten Datenbits gezählt werden und, sofern sie in den Zwischenspeicher eingeschrieben werden, auch summarisch erfasst werden, so dass stets bekannt ist, wie viele Datenbits im Moment im Zwischenspeicher eingeschrieben sind.

Im Hinblick auf einen optimierten Auslesebetrieb der eingeschriebenen Datenbits aus dem Zwischenspeicher ist es zweckmäßig, die im als Schieberegister ausgebildeten Zwischenspeicher befindlichen Datenbits vor dem Einschreiben neuer Datenbits um die Anzahl der neu hinzukommenden Datenbits zu verschieben. Dies ermöglicht es, mit jedem Ausleseschritt jeweils die am längsten bereits im Zwischenspeicher befindlichen Datenbits auszulesen und so einen first-in-first-out-Auslesebetrieb (FIFO) zu realisieren.

Nach einer zweckmäßigen Erfindungsausgestaltung ist vorgesehen, dass die ausgewählten, gegebenenfalls bereits im Zwischenspeicher abgelegten Datenbits als Speicherdatenwort unter Verwendung eines m Arbeitsbits enthaltenden und das Ausgabeformat definierenden Arbeitsbitregisters zum Ausgeben an einen Speicher oder dergleichen aufbereitet werden. Nach dieser Erfindungsausgestaltung kommt also ein zweites Register zum Einsatz, anhand welchem das Ausgabeformat der gesampelten Datenbits für eine beliebige, sich an das Bitsampling anschließende Weiterverarbeitung definiert wird. Auch hier ist es dem Programmierer möglich, durch entsprechende Belegung des Arbeitsbitregisters ein beliebiges Ausgabeformat zu definieren.

Auch der Auslesebetrieb selbst kann variabel gestaltet werden. Die Ausgabe eines im Zwischenspeicher abgelegten Datenworts kann abhängig von der Anzahl der im Zwischenspeicher befindlichen Datenbits erfolgen, also erst dann, wenn eine bestimmte Anzahl x an Datenbits eingeschrieben ist. Alternativ kann auch nach jedem Arbeitszyklus des Prozessors eine Ausgabe erfolgen. Hierbei wird also nach jedem puncturing-Schritt versucht, ein Datenwort einer bestimmten Größe aus dem Zwischenspeicher auszulesen und z. B. in den weiteren Speicher einzuschreiben.

Im Rahmen der Definition des Ausgabeformats ist es möglich, eine vorbestimmte Anzahl an Datenbits aus dem Zwischenspeicher auszugeben. Unter Verwendung des Arbeitsbitregisters kann also eine bestimmte Länge des für jeden Ausleseschritt aus dem Zwischenspeicher ausgelesenen Datenworts definiert werden. Beispielsweise kann ein Auslesen nur dann erfolgen, wenn mindestens so viele Datenbits im Zwischenspeicher sind, wie zum Ausgeben vorbestimmt sind. Durch das eingangs bereits erwähnte Zählen der in den Zwischenspeicher eingeschriebenen Datenbits ist es dem Arbeitsprozessor kontinuierlich möglich, das Auslesen aus dem Zwischenspeicher nur dann anzustoßen, wenn es hinsichtlich der im Zwischenspeicher befindlichen Bits auch möglich ist.

Eine weitere Erfindungsausgestaltung sieht vor, dass das aus dem Zwischenspeicher ausgelesene Datenwort durch Hinzufügung eines oder mehrerer weiterer Datenbits verlängert wird. Diese Verlängerung ist dann erforderlich, wenn die Anzahl der ausgelesenen Datenbits kleiner als die vorbestimmte Bitzahl des Speicherdatenwortes ist. Ist beispielsweise entsprechend den zu verarbeitenden Datenworten und dem entsprechenden Auswahlregister auch hier ein sechzehn Bit langes Speicherdatenwort definiert, so werden beispielsweise bei einer vorbestimmten Länge des aus dem Zwischenspeicher auszulesenden Datenworts von zwölf Bit die freien vier Bit entsprechend gefüllt, je nachdem wie dies seitens des Programmierers vorgeschrieben ist. Dabei besteht zum einen die Möglichkeit, eine sogenannte "sign extension" durchzuführen. Sofern dies vorgesehen ist wird in die noch freien oberen Zellen des Ausgabedatenworts das gleiche Vorzeichen geschrieben wie es das aus dem Zwischenspeicher ausgelesene Datenwort besitzt. Falls diese Option nicht gewählt ist wird in die freien oberen Zellen jeweils ein Bit eingeschrieben, wie es seitens des Programmierers vorgegeben ist.

Weiterhin kann nach einer Erfindungsausgestaltung vorgesehen sein, dass das aus dem Zwischenspeicher ausgelesene Datenwort innerhalb des Ausgabedatenworts verschoben wird. Dies bietet die Möglichkeit das ausgelesene Datenwort innerhalb des beispielsweise sechzehn Bit langen Ausgabedatenworts an beliebiger Stelle anzuordnen und in die unteren freien Zellen jeweils die eine "0" zu setzen ("shift left").

Insgesamt bietet das erfindungsgemäße Verfahren zum einen die Möglichkeit eines sehr schnellen Bit-samplings bzw. Bit-puncturings, gleichzeitig wird die Möglichkeit gegeben, die sehr schnell gesampelten Daten auch auf einfache und schnelle Weise in ein beliebiges Ausgabedatenformat zu überführen.

Neben dem Verfahren betrifft die Erfindung ferner eine Vorrichtung zur Durchführung des beschriebenen Verfahrens. Diese zeichnet sich durch einen Arbeitsprozessor und eine Datenbit-Auswahleinheit zum Auswählen eines oder mehrerer bestimmter Datenbits aus einem n Datenbits umfassenden Datenwort anhand eines n Auswahlbits umfassenden Auswahlbitregisters, dessen Auswahlbits angeben, ob ein Datenbit des Datenworts auszuwählen ist, wobei die Auswahl innerhalb eines Arbeitszyklus des Arbeitsprozessors erfolgt.

Bei der erfindungsgemäßen Vorrichtung, die beispielsweise Teil eines mobilen Telekommunikationsgeräts wie einem tragbaren Telefon oder dergleichen ist, kann zweckmäßigerweise ferner vorgesehen sein, dass das Auswahlbitregister aus einem mehrere Auswahlregister umfassenden Auswahlregisterspeicher in die Daten-Auswahleinheit einladbar ist. Dies ermöglicht es, zu jedem im Rahmen eines Arbeitszyklus eingeladenen und zu bearbeitenden Datenwort ein bestimmtes Auswahlbitregister einzuladen. Insgesamt gestaltet sich der Auswahlbetrieb äußerst flexibel.

Weiterhin kann zweckmäßigerweise ein als Schieberegister ausgebildeter Zwischenspeicher vorgesehen sein, in den die innerhalb eines Arbeitszyklus ausgewählten Datenbits einspeicherbar sind. Ferner kann ein Zähler zum Zählen der innerhalb eines Arbeitszyklus ausgewählten Datenbits und zum Aufsummieren der Bitanzahlen mehrerer Arbeitszyklen vorgesehen sein. Dabei kann die Vorrichtung derart ausgebildet sein, dass bereits im Zwischenspeicher befindliche Datenbits in Abhängigkeit der gezählten Anzahl neu einzuschreibender Datenbits verschiebbar sind.

Zur Bestimmung des Ausgabeformats eines Ausgabedatenworts, das anhand der ausgewählten und im Zwischenspeicher gesampelten Datenbits gebildet wird, zu definieren hat es sich als besonders vorteilhaft erwiesen, wenn wenigstens ein m Arbeitsbits enthaltendes und das Ausgabeformat definierendes Arbeitsbitregister vorgesehen ist, mittels welchem aus dem Zwischenspeicher ausgelesene Datenbits zur Ausgabe in Form eines Ausgabendatenworts aufbereitet werden. Dieses Ausgabebitregister ist Grundlage dafür, wie das Ausgabedatenwort gebildet bzw. aufgebaut und die ausgewählten Datenbits innerhalb des Ausgabedatenworts angeordnet sind.

Das Arbeitsbitregister selbst kann einen den Zähler bildenden ersten Registerabschnitt umfassen, das heißt, der Zähler selbst ist Teil des Arbeitsbitregisters. Weiterhin kann ein zweiter Zählerabschnitt vorgesehen sein, mittels welchem die Anzahl der aus dem Zwischenspeicher auszulesenden Datenbits definiert ist. Schließlich kann ein dritter Registerabschnitt vorgesehen sein, mittels welchem die ausgelesenen Datenbits innerhalb des Ausgabedatenworts verschoben werden können, mittels dem also die Positionierung der ausgelesenen Datenbits definiert wird.

Über einen vierten und einen fünften Registerabschnitt ist es möglich zu definieren, wie das aus m Datenbits bestehende Ausgabedatenwort bei n aus dem Zwischenspeicher ausgelesenen Datenbits mit n ≤ m zu komplettieren ist. Diese Registerabschnitte geben also an, ob eine "sign extension", also eine Wiederholung des Vorzeichenbits zum Füllen der noch freien Zellen des z. B. sechzehn Bit langen Ausgabedatenworts erfolgen soll, oder ob beispielsweise ein definierter Bitwert in die freien Zellen unabhängig von den eingelesenen Datenbits verwendet werden soll. Schließlich kann ein sechster Registerabschnitt vorgesehen sein, mittels dem der Ausgabemodus einstellbar ist.

Generell können die gesampelten Bits z.B. zwecks Speicherung in einem Ausgabewert ausgelesen werden. Die Speicherung erfolgt in der Regel über einen Zeiger (Pointer), der nach (post) (oder auch vor (pre)) der eigentlichen Speicherung verändert wird (increment oder decrement). Diese Pointeränderung (pointer update) ist im ersten Modus nur dann aktiviert, wenn der Bitzählerstand >= der definierten Anzahl ist, d.h. die Abspeicherung des Ausgabewertes erfolgt immer bei jedem Lesen der Ausgabe, die Zeigerveränderung wird aber gegebenenfalls unterdrückt. Im zweiten Modus wird die Zeigerveränderung nicht mehr unterdrückt, d.h. der "pointer update" ist permanent aktiviert.

Weitere Vorteile, Merkmale und Einzelheiten der Erfindung ergeben sich aus dem im Folgenden beschriebenen Ausführungsbeispiel sowie anhand der Zeichnungen. Dabei zeigen:
- Fig. 1: eine Prinzipskizze einer erfindungsgemäßen Vorrichtung,
- Fig. 2: eine Prinzipskizze des Auswählens von Datenbits und Zwischenspeicherung in einem Zwischenspeicher, und
- Fig. 3: eine Prinzipskizze zur Darstellung der Aufbereitung der zwischengespeicherten Datenbits anhand eines Arbeitsbitregisters zur Bildung des Ausgabedatenworts.

Fig. 1 zeigt in Form einer Prinzipskizze eine erfindungsgemäße Vorrichtung, mittels welcher es möglich ist, aus einem Datenwort beliebige gewünschte Datenbits zu extrahieren, wobei dies innerhalb eines Arbeitszyklus eines Arbeitsprozessors erfolgt. Vorauszuschicken ist, dass die vorliegenden Beispiele anhand eines sechzehn Bit langen Datenworts, eines sechzehn Bit langen Auswahlbitregisters, eines sechzehn Bit umfassenden Arbeitsbitregisters und eines sechzehn Bit langen Ausgabedatenworts beschrieben wird. Selbstverständlich ist es auch möglich, andere Konfigurationen, beispielsweise acht-Bit-Wörter bzw. Register zu verwenden.

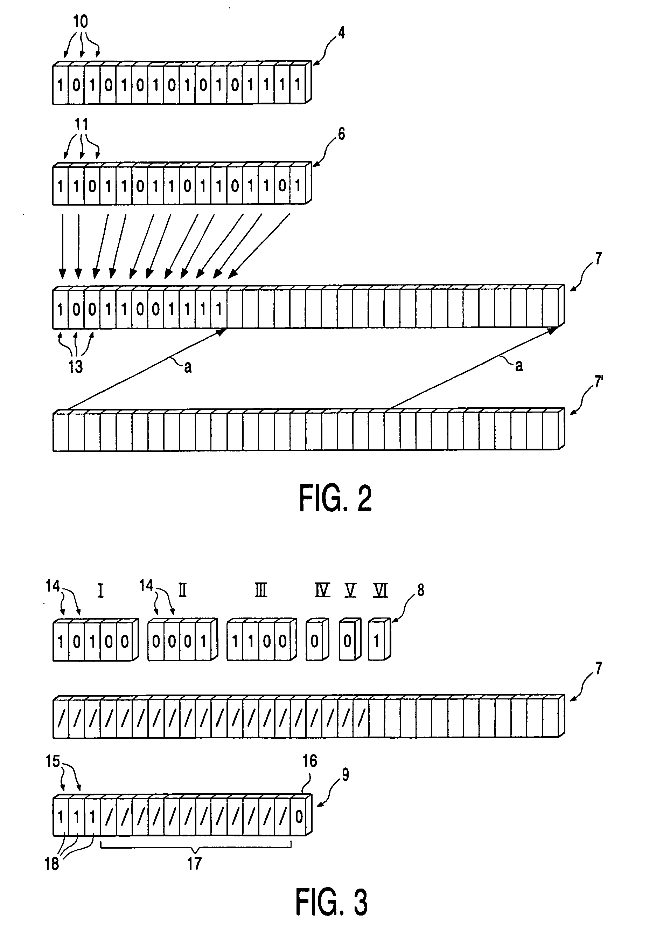

Die erfindungsgemäße Vorrichtung besteht aus einer Datenbit-Auswahleinheit 1 mit zugeordnetem Arbeitsprozessor 2. Die Datenbit-Auswahleinheit 1 lädt aus einem Datenwortspeicher 3 jeweils ein Datenwort 4 bestehend aus n Datenbits ein, um aus diesem bestimmte Datenbits auszuwählen. Parallel zum eingeladenen Datenwort 4 wird aus einem Auswahlbitregisterspeicher 5, in dem eine Vielzahl von Auswahlbitregister 6 hinterlegt sind, ein Auswahlbitregister 6 eingeladen. Dieses Auswahlbitregister besteht ebenfalls aus n Auswahlbits. Jedes Auswahlbit ist einem Datenbit des eingeladenen Datenworts 4 zugeordnet. Ein Auswahlbit gibt an, ob das zugeordnete Datenbit auszuwählen ist oder nicht. Der gesamte Betrieb erfolgt unter Verwendung des Arbeitsprozessors 2. Die Auswahl sämtlicher aus einem Datenwort zu wählenden Datenbits erfolgt innerhalb eines Arbeitszyklus des Arbeitsprozessors 2. Anschließend werden die ausgewählten Datenbits in einen Zwischenspeicher 7 gespeichert. Soll nun aus diesem Zwischenspeicher ein bestimmtes Ausgabedatenwort zur Weiterverarbeitung, sei es zum Ablegen in einem weiteren Speicher oder zur unmittelbaren Weiterverarbeitung, ausgegeben werden, so werden aus dem Zwischenspeicher 7 gemäß der Vorgabe durch ein Arbeitsbitregister 8 eine bestimmte Anzahl m an zwischengespeicherten Datenbits ausgewählt, die dann entsprechend aufbereitet werden, um das Ausgabedatenwort 9 zu bilden und auszugeben. Die konkrete Arbeitsweise wie auch die Konfiguration der jeweiligen Register wird anhand eines Ausführungsbeispiels der Fig. 2 und 3 beschrieben.

Fig. 2 zeigt ein Datenwort 4 bestehend aus insgesamt sechzehn Datenbits 10, die unterschiedliche Werte "0" und "1" besitzen. Dem Datenwort 4 ist ein Auswahlbitregister 6 zugeordnet, das ebenfalls im gezeigten Beispiel aus insgesamt sechzehn Auswahlbits 11 unterschiedlicher Wertigkeit "0" und "1" besteht. Jeweils ein Auswahlbit 11 ist einem Datenbit 10 zugeordnet.

Über die Auswahlbits 11 wird nun vorgegeben, welches zugeordnete Datenbit auszuwählen und in den Zwischenspeicher 7, der hier als Schieberegister bestehend aus insgesamt einunddreißig Bits 12 ausgeführt ist, einzuschreiben ist. Im gezeigten Beispiel wird jedes Datenbit 10 ausgewählt, dem ein Datenbit 11 mit der Wertigkeit "1" zugeordnet ist. Im gezeigten Beispiel werden aus dem Datenwort 4 insgesamt elf Datenbits ausgewählt (im Auswahlbitregister 6 sind insgesamt elf Auswahlbits mit der Wertigkeit "1" eingeschrieben). Diese ausgewählten Datenbits 10 werden als Auswahldatenbits 13 in die entsprechenden Bitzellen des Zwischenspeichers 7 eingeschrieben. Dies alles geschieht innerhalb eines Arbeitszyklus des Arbeitsprozessors 2, das heißt, innerhalb eines Arbeitszyklus wird jeweils ein Datenwort 4 vollständig bearbeitet und sämtliche aus ihm auszuwählenden Datenbits ausgewählt. Die ausgewählten insgesamt elf Auswahldatenbits 13 werden jeweils in den linken freien Bitzellenblock des Zwischenspeichers 7 eingeschrieben. Die vorher im Zwischenspeicher 7 befindliche Datenbits, die im vorhergehenden Auswahlzyklus eingeschrieben wurden, werden im Schieberegisterspeicher nach rechts verschoben, und zwar soweit, wie neue Datenbits eingeschrieben werden. Zu diesem Zweck ist ein Zähler (worauf nachfolgend noch eingegangen wird) vorgesehen, der die entsprechenden Auswahlbits des Auswahlregisters 6 zählt und die Verschiebung steuert. In Fig. 2 ist dies mit dem unterhalb des Zwischenspeichers 7 dargestellten Zwischenspeichers 7' dargestellt, der die Situation zeigt, bevor der oberhalb dargestellte Auswahl- oder puncturing-Schritt durchgeführt wurde. Durch die beiden Pfeile a ist dargestellt, dass die jeweiligen eingeschriebenen Bits entsprechend verschoben werden und wie dargestellt im Zwischenspeicher 7 dann nach rechts gerückt sind.

Fig. 3 zeigt nun den weiteren Fortgang des Auswahl- oder puncturings-Verfahrens, in welchem die Auswahldatenbits aus dem Zwischenspeicher 7 ausgelesen und gemäß einem vorgegebenen Datenformat aufbereitet werden. Zu diesem Zweck ist ein Arbeitsbitregister 8 vorgesehen, welches das Ausgabedatenformat definiert. Das Arbeitsbitregister 8 besteht aus insgesamt sechs Registerblöcken I, II, III, IV, V und VI und insgesamt sechzehn Arbeitsbits 14, die entsprechend auf die Registerblöcke I - VI verteilt sind.

Der erste Registerblock I bildet den Zähler, der einerseits die Anzahl der Bits zählt, die im jeweiligen Arbeitszyklus auszuwählen und in den Zwischenspeicher 7 zu schreiben sind. Diese Kenntnis ist dahingehend relevant als um diese Anzahl die bereits eingeschriebenen Datenbits im Zwischenspeicher 7 verschoben werden müssen. Zum anderen werden die bereits im Zwischenspeicher 7 befindlichen Bits sowie die Anzahl der neu eingeschriebenen Bits aufsummiert, so dass der Zähler auch Auskunft darüber gibt, wie der Belegungszustand im Zwischenspeicher 7 ist. Da der Zwischenspeicher 7 aus insgesamt einunddreißig Bitzellen besteht muss der Zähler zur binären Darstellung der Bitzahl insgesamt fünf Bits 14 umfassen.

Der Registerabschnitt II dient zur Angabe, wo die aus dem Zwischenspeicher 7 ausgelesenen Datenbits im zu bildenden Ausgabedatenwort positioniert sind. Das auszugebende Datenwort 9 besteht ebenfalls aus insgesamt sechzehn Datenbits 15. Über den Registerabschnitt II wird nun angegeben, ob und wie viele führende "0" Bits den ausgelesenen Datenbits im Ausgabedatenwort 9 vorangesetzt werden.

Der Registerabschnitt III definiert, wie viele Auswahldatenbits 13 aus dem Zwischenspeicher 7 auszuwählen sind. Dies können maximal sechzehn sein, da das Ausgabedatenwort aus sechzehn Datenbits besteht.

Der Registerabschnitt IV definiert, wie der Ausgabemodus ist. Je nachdem, ob dort eine "0" oder eine "1" eingeschrieben ist, wird eine Ausgabe nur dann erfolgen, wenn im Zwischenspeicher 7 die Mindestanzahl an auszulesenden Datenbits wie durch den Registerabschnitt III vorgegeben ist erreicht ist, wobei dies unter Beachtung des Zählerstandes geschieht. Das heißt, es erfolgt ein Auslesen nur wenn der Zählerstand hinreichend hoch ist und mindestens so viele Datenbits eingeschrieben sind wie durch den Registerabschnitt III vorgegeben wird. Im anderen Modus erfolgt unabhängig vom Zählerstand nach jedem Auswahlzyklus ein Ausleseversuch aus dem Zwischenspeicher 7 sowie ein Einschreibeversuch beispielsweise in einem externen Speicher.

Die Registerabschnitte VI und VII dienen schließlich dazu anzugeben, wie die freien Bits 15 des Ausgabedatenworts zu belegen sind, wenn weniger als sechzehn Datenbits aus dem Zwischenspeicher 7 ausgelesen werden und wenn nicht so viele führende "0" Bits gesetzt werden, dass insgesamt sämtliche sechzehn Datenbits 15 des Ausgabedatenworts belegt sind. Je nachdem wie der Registerabschnitt V belegt ist erfolgt entweder eine sogenannte "sign extension", das heißt, die noch freien Datenbits des Ausgabedatenworts 9 werden mit Bits belegt, die gleich dem Vorzeichen-Bit des aus dem Zwischenspeicher 7 ausgelesenen Datenworts sind. Es erfolgt also eine Vorzeichenwiederholung. Bei einer anderen Belegung des Registerabschnitts V wird der Bitwert eingeschrieben, der im Registerabschnitt VI vorgegeben ist.

Im gezeigten Ausführungsbeispiel sind im Registerspeicher 7 wie einerseits durch die Querstriche angedeutet zwanzig beliebige Datenbits eingeschrieben, entsprechend lautet der Zählerstand im Registerabschnitt I "10100". Wie dem Registerabschnitt III zu entnehmen ist sollen insgesamt zwölf Datenbits ausgelesen werden (Datenbitbelegung im Registerabschnitt III "1100". Es werden jeweils die zwölf rechten Datenbits ausgelesen.

Der Registerabschnitt II "0001" gibt an, dass eine führende Null vor die zwölf auszulesenden Datenbits gesetzt werden soll, was im Ausgabedatenwort 9 anhand des Datenbits 16 dargestellt ist. Dem Datenbit folgen die zwölf Datenbits 17, die ausgelesen wurden. Die restlichen drei Datenbits 18 werden jeweils mit einer "1" belegt. Im Registerabschnitt V ist eine "0" eingetragen was bedeutet, dass die "sign extension", also die mehrfache Wiederholung des Vorzeichenbits der ausgelesenen Datenbits, ausgeschalten ist und der im Registerabschnitt VI eingeschriebene Wert "1" eingeschrieben wird.

Das auf diese Weise gebildete Ausgabedatenwort 9 wird nun zur beliebigen Weiterverarbeitung, beispielsweise zur Speicherung in einem externen Speicher oder dergleichen ausgegeben.

Findet die Ausgabe statt, so wird der Bit-Zähler um die Anzahl der ausgegebenen Bits (in diesem Fall zwölf) entsprechend vermindert.

Schließlich ist im Registerabschnitt IV eine "0" eingetragen. Diese besagt, dass in diesem Fall die Ausgabe nur dann erfolgen soll, wenn der Zählerstand im Registerabschnitt I ≥ der im Registerabschnitt III angegebenen Anzahl der auszulesenden Datenbits ist.

Das erfindungsgemäße Verfahren sowie die erfindungsgemäße Vorrichtung kommen zweckmäßigerweise bei einer Einrichtung zur mobilen Telefonie zum Einsatz. Das beschriebene Verfahren lässt beispielsweise ein sogenanntes "random-puncturing" (Punktierung ohne regelmäßige Wiederholung des Punktierungsschemas) zu, daneben ist beispielsweise eine Trennung zwischen geraden und ungeraden Datenbits aus den eingehenden Datenworten möglich. Eine weitere Möglichkeit besteht darin, eine sogenannte "hard decision bit extraction" durchzuführen, bei welcher aus einem aus vier Bitblöcken à vier Bits bestehenden Datenwort jeweils die vier Vorzeichenbits mittels des Auswahlbitregisters ausgewählt werden.

## Patentansprüche

1. Verfahren zum Auswählen, puncturing, von Datenbits (10) aus einem Datenwort (4) in einem Datenverarbeitungssystem, insbesondere einem Kommunikationssystem, bei welchem Verfahren innerhalb eines Arbeitszyklus eines Arbeitsprozessors das oder die Datenbits des n Datenbit umfassenden Datenworts anhand eines n Auswahlbit umfassenden Auswahlbitregisters (6), dessen Auswahlbits (11) angeben, ob ein Datenbit des Datenworts auszuwählen ist, ausgewählt werden, bei welchem die ausgewählten Datenbits in einen Zwischenspeicher (7) geschrieben werden, und bei welchem die bereits im als Schieberegister ausgebildeten Zwischenspeicher (7) befindlichen Datenbits vor dem Einschreiben neuer Datenbits um die Anzahl der neuen Datenbits verschoben werden.

2. Verfahren nach Anspruch 1, bei welchem die innerhalb eines Arbeitszyklus ausgewählten Datenbits gezählt werden.

3. Verfahren nach Anspruch 2, bei welchem die Anzahl der in den Zwischenspeicher (7) eingeschriebenen Datenbits summarisch erfasst wird.

4. Verfahren nach einem der vorangehenden Ansprüche, bei welchem die ausgewählten, gegebenenfalls bereits im Zwischenspeicher (7) abgelegten Datenbits als Ausgabedatenwort unter Verwendung eines m Arbeitsbits enthaltenden und das Ausgabeformat definierenden Arbeitsbitregisters (8) zum Ausgeben an einen Speicher o. dgl. aufbereitet werden.

5. Verfahren nach Anspruch 4, bei welchem die Ausgabe abhängig von der Anzahl der im Zwischenspeicher (7) befindlichen Datenbits oder nach jedem Arbeitszyklus des Arbeitsprozessors erfolgt.

6. Verfahren nach Anspruch 4 oder 5, bei welchem eine vorbestimmte Anzahl an Datenbits aus dem Zwischenspeicher (7) ausgegeben werden.

7. Verfahren nach einem der Ansprüche 4 bis 6, bei welchem das aus dem Zwischenspeicher (7) ausgelesene Datenwort durch Hinzufügen eines oder mehrere weiterer Datenbits verlängert wird.

8. Verfahren nach einem der Ansprüche 4 bis 7, bei welchem das aus dem Zwischenspeicher (7) ausgelesene Datenwort innerhalb des Ausgabedatenworts verschoben wird.

9. Vorrichtung zur Dürchführung des Verfahren nach einem der Ansprüche 1 bis 8, mit einem Arbeitsprozessor (2) und einer Datenbit-Auswahleinheit (1) zum Auswählen eines oder mehrere bestimmter Datenbits aus einem n Datenbits (10) umfassenden Datenwort (4) anhand eines n Auswahlbits (11) umfassenden Auswahlbitregisters (6), dessen Auswahlbits (11) angeben, ob ein Datenbit (10) des Datenworts (6) auszuwählen ist, **dadurch gekennzeichnet, dass** die Auswahl innerhalb eines Arbeitszyklus des Arbeitsprozessors (2) erfolgt, wobei ein als Schieberegister ausgebildeter Zwischenspeicher (7) vorgesehen ist, in den die innerhalb eines Arbeitszyklus ausgewählten Datenbits (10) einspeicherbar sind, und bereits im Zwischenspeicher (7) befindliche Datenbits in Abhängigkeit der Anzahl neu einzuschreibender Datenbits (10) verschiebbar sind.

10. Vorrichtung nach Anspruch 9,
**dadurch gekennzeichnet,**
**dass** das Auswahlbitregister (6) aus einem mehrere Auswahlbitregister (6) umfassenden Auswahlbitregisterspeicher (5) in die Datenbit-Auswahleinheit (1) ladbar ist.

11. Vorrichtung nach einem der Ansprüche 9 oder 10
**dadurch gekennzeichnet,**
**dass** ein Zähler zum Zählen der innerhalb eines Arbeitszyklus ausgewählten Datenbits (10) und zum Aufsummieren der Bitanzahlen mehrere Arbeitszyklen vorgesehen ist.

12. Vorrichtung nach einem der Ansprüche 9 bis 11,
**dadurch gekennzeichnet,**
**dass** wenigstens ein m Arbeitsbits (14) enthaltendes und das Ausgabeformat definierendes Arbeitsbitregister (8) vorgesehen ist, mittels welchem aus dem Zwischenspeicher (7) ausgelesene Datenbits zur Ausgabe in Form eines Ausgabedatenworts (9) aufbereitet werden.

13. Vorrichtung nach Anspruch 12,
**dadurch gekennzeichnet,**
**dass** das Arbeitsbitregister (8) einen den Zähler bildenden ersten Registerabschnitt (I) umfasst.

14. Vorrichtung nach Anspruch 12 oder 13,
**dadurch gekennzeichnet,**
**dass** ein zweiter Zählerabschnitt (II) vorgesehen ist, mittels welchem die Anzahl der aus dem Zwischenspeicher (7) auszulesenden Datenbits (13) definiert ist.

15. Vorrichtung nach einem der Ansprüche 12 bis 14,
**dadurch gekennzeichnet,**
**dass** ein dritter Registerabschnitt (III) vorgesehen ist, mittels welchem die ausgelesenen Datenbits (15) innerhalb des Ausgabedatenworts (9) verschoben werden können.

16. Vorrichtung nach einem der Ansprüche 12 bis 15,
**dadurch gekennzeichnet,**
**dass** ein vierter und ein fünfter Registerabschnitt (IV, V) vorgesehen sind, mittels denen definiert wird, wie das aus m Datenbits (15) bestehende Ausgabedatenwort (9) bei n aus dem Zwischenspeicher (7) ausgelesenen Datenbits mit n < m zu komplettieren ist.

17. Vorrichtung nach einem der Ansprüche 12 bis 16,
**dadurch gekennzeichnet,**
**dass** ein sechster Registerabschnitt (VI) vorgesehen ist, mittels dem der Ausgabemodus einstellbar ist.

18. Vorrichtung nach Anspruch 17,
**dadurch gekennzeichnet,**
**dass** in den sechsten Registerabschnitt (VI) ein Bit eingeschrieben oder einschreibbar ist, anhand dessen Wertigkeit zwischen einem ersten Ausgabemodus, bei dem die Änderung eines vor oder nach dem Auslesen änderbaren, einen Speicherplatz angebenden pointers unterdrückt wird, bis der Zählerstand ≤ der definierten Anzahl ist, und einem zweiten Modus, bei dem eine Änderung des pointers unabhängig vom Zählerstand immer zugelassen ist, gewählt wird.

19. Vorrichtung nach einem der Ansprüche 9 bis 18,
**dadurch gekennzeichnet,**
**dass** sie Teil einer tragbaren Telekommunikationseinrichtung für die mobile Telekommunikation ist.

## Claims

1. Method for selecting, puncturing, of data bits (10) from a data word (4) in a data processing system, in particular a communication system, in which method, within one operating cycle of an operating processor, the one or more data bits of the data word, which comprises n data bits, is selected using a selection bit register (6), which comprises n selection bits and whose selection bits (11) indicate if a data bit of the data word is to be selected, in which method the selected data bits are written into an intermediate memory (7), and in which method the data bits already present in the intermediate memory (7), which is configured as a shift register, are shifted before the writing of new data bits by the number of the new data bits.

2. Method according to claim 1, wherein the data bits selected within an operating cycle are counted.

3. Method according to claim 2, wherein the sum of the number of data bits written into the intermediate memory (7) is determined.

4. Method according to any of the previous claims, wherein the data bits selected and, if applicable, already stored in the intermediate memory (7) are processed as an output data word using an operating bit register (8), which comprises m operating bits and defines the output format, for output to a memory or the like.

5. Method according to claim 4, wherein the output is carried out depending on the number of data bits in the intermediate memory (7) or after each operating cycle of the operating processor.

6. Method according to claim 4 or 5, wherein a predetermined number of data bits are output from the intermediate memory (7).

7. Method according to any of claims 4 to 6, wherein the data word read from the intermediate memory (7) is extended via adding one or more further data bits.

8. Method according to any of claims 4 to 7, wherein the data word read from the intermediate memory (7) is shifted within the output data word.

9. Apparatus for carrying out the method according to any of claims 1 to 8, having an operating processor (2) and a data bit selection unit (1) for selecting one or more specific data bits from a data word (4), which comprises n data bits (10), using a selection bit register (6), which comprises n selection bits (11) and whose selection bits (11) indicate if a data bit (10) of the data word (6) is to be selected, **characterized in that** the selection takes place within one operating cycle of the operating processor (2), wherein an intermediate memory (7) configured as a shift register is provided, in which the data bits (10) selected within an operating cycle can be stored and in which data bits already present in the intermediate memory (7) can be shifted depending on the number of new data bits (10) to be written.

10. Apparatus according to claim 9, **characterized in that** the selection bit register (6) is loadable into the data bit selection unit (1) from a selection bit register memory (5) comprising a plurality of selection bit registers (6).

11. Apparatus according to any of claims 9 or 10, **characterized in that** a counter is provided for counting of data bits (10) selected during an operating cycle and for summing the number of bits of a plurality of operating cycles.

12. Apparatus according to any of claims 9 to 11, **characterized in that** at least one operating bit register (8) is provided, which comprises m operating bits (14) and defines the output format and by means of which data bits read from the intermediate memory (7) are processed for output in the form of an output data word (9).

13. Apparatus according to claim 12, **characterized in that** the operating bit register (8) comprises a first register section (I) forming the counter.

14. Apparatus according to claim 12 or 13, **characterized in that** a second register section (II) is provided, by means of which the number of data bits (13) to be read from the intermediate memory (7) is defined.

15. Apparatus according to any of claims 12 to 14, **characterized in that** a third register section (III) is provided, by means of which the read data bits (15) can be shifted within the output data word (9).

16. Apparatus according to one of claims 12 to 15, **characterized in that** a fourth and fifth register section (IV, V) are provided, by means of which it is defined how the output data word (9) consisting of m data bits (15) is to be completed in case of n data bits being read from the intermediate memory (7) with n<m.

17. Apparatus according to one of claims 12 to 16, **characterized in that** a sixth register section (VI) is provided, by means of which the output mode is adjustable.

18. Apparatus according to claim 17, **characterized in that** a bit is written in the sixth register section (VI) or a bit can be written into the sixth register section (VI), wherein one of a first output mode and a second mode is selected in accordance with the value of the bit, wherein, in the first mode, the change of a pointer, which can be changed before or after the reading and which indicates a memory position, is suppressed until the count is ≤ the defined number, and wherein, in the second mode, a change of the pointer is always allowed irrespective of the count.

19. Apparatus according to any of claims 9 to 18, **characterized in that** it is part of a portable telecommunications device for mobile telecommunications.

## Revendications

1. Procédé la sélection, puncturing , de bits d'informations (10) à partir d'un mot de données (4) dans un système de traitement de données, en particulier un système de communication, procédé dans lequel, au sein d'un cycle de travail d'un processeur de travail, le ou les bits d'informations du mot de données comprenant n bits d'informations sont sélectionnés à l'aide d'un registre de bits de sélection (6) comprenant n bits de sélection, les bits de sélection (11) indiquant le fait de savoir si un bit d'informations du mot de données doit être sélectionné, dans lequel les bits d'informations sélectionnés sont introduits par écriture dans une mémoire intermédiaire (7), et dans lequel les bits d'informations se trouvant déjà dans la mémoire intermédiaire réalisée sous la forme d'un registre à décalage sont soumis à un décalage, avant l'inscription de nouveaux bits d'informations, correspondant au nombre des nouveaux bits d'informations.

2. Procédé selon la revendication 1, dans lequel les bits d'informations sélectionnés au sein d'un cycle de travail sont comptés.

3. Procédé selon la revendication 2, dans lequel le nombre de bits d'informations inscrits dans la mémoire intermédiaire (7) est soumis à une détermination sommaire.

4. Procédé selon l'une quelconque des revendications précédentes, dans lequel les bits d'informations sélectionnés, le cas échéant déjà placés dans la mémoire intermédiaire (7), sont traités sous la forme d'un mot de données de sortie en utilisant un registre de bits de travail (8) contenant m bits de travail et définissant le format de sortie, pour les faire passer à une mémoire ou analogue.

5. Procédé selon la revendication 4, dans lequel la sortie a lieu en fonction du nombre de bits de données se trouvant dans la mémoire intermédiaire (7) ou après chaque cycle de travail du processeur de travail.

6. Procédé selon la revendication 4 ou 5, dans lequel on fait sortir un nombre prédéterminé de bits d'informations de la mémoire intermédiaire (7).

7. Procédé selon l'une quelconque des revendications 4 à 6, dans lequel le mot de données extrait par lecture de la mémoire intermédiaire (7) est prolongé en y ajoutant un ou plusieurs bits d'informations supplémentaires.

8. Procédé selon l'une quelconque des revendications 4 à 7, dans lequel le mot de données extrait par lecture de la mémoire intermédiaire (7) est décalé à l'intérieur du mot de données de sortie.

9. Dispositif pour la mise en oeuvre du procédé selon l'une quelconque des revendications 1 à 8, comprenant un processeur de travail (2) et une unité de sélection de bits d'informations (1) pour la sélection d'un ou de plusieurs bits d'informations déterminés à partir d'un mot de données (4) comprenant n bits d'informations (10) à l'aide d'un registre de bits de sélection (6) comprenant n bits de sélection (11), les bits de sélection (11) indiquant le fait de savoir si un bit d'informations (10) du mot de données (6) doit être sélectionné, **caractérisé en ce que** la sélection a lieu au sein d'un cycle de travail du processeur de travail (2), en prévoyant une mémoire intermédiaire (7) réalisée sous la forme d'un registre à décalage, dans laquelle les bits d'informations (10) qui sont sélectionnés au sein d'un cycle de travail peuvent être stockés et des bits d'informations se trouvant déjà dans la mémoire intermédiaire (7) peuvent être décalés en fonction du nombre de bits d'informations (10) nouvellement introduit par écriture.

10. Dispositif selon la revendication 9, **caractérisé en ce que** le registre de bits de sélection (6) peut être chargé depuis une mémoire de registre de bits de sélection (5) comprenant plusieurs registres de bits de sélection (6) jusque dans l'unité de sélection de bits d'informations (1).

11. Dispositif selon l'une quelconque des revendications 9 ou 10, **caractérisé en ce qu'**on prévoit un compteur pour compter les bits d'informations (10) sélectionnés au sein d'un cycle de travail et pour additionner les nombres de bits de plusieurs cycles de travail.

12. Dispositif selon l'une quelconque des revendications 9 à 11, **caractérisé en ce qu'**on prévoit au moins un registre de bits de travail (8) contenant m bits de travail (14) et définissant le format de sortie, au moyen duquel des bits d'informations extraits par lecture de la mémoire intermédiaire (7) sont traités à des fins de sortie sous la forme d'un mot de données de sortie (9).

13. Dispositif selon la revendication 12, **caractérisé en ce que** le registre de bits de travail (8) comprend une première section de registre (I) qui forme le compteur.

14. Dispositif selon la revendication 12 ou 13, **caractérisé en ce qu'**on prévoit une deuxième section de compteur (II) au moyen de laquelle on définit le nombre de bits d'informations (12) qui doivent être extraits par lecture de la mémoire intermédiaire (7).

15. Dispositif selon l'une quelconque des revendications 12 à 14, **caractérisé en ce qu'**on prévoit une troisième section de registre (III) au moyen de laquelle les bits d'informations (15) qui ont été extraits par lecture sont soumis à un décalage au sein du mot de données de sortie (9).

16. Dispositif selon l'une quelconque des revendications 12 à 15, **caractérisé en ce qu'**on prévoit une quatrième et une cinquième section de registre (IV, V), au moyen desquelles on définit la façon dont le mot de données de sortie (8) constitué par m bits d'informations (15) doit être complété par n bits d'informations extraits par lecture de la mémoire intermédiaire (7), n étant inférieur à m.

17. Dispositif selon l'une quelconque des revendications 12 à 16, **caractérisé en ce qu'**on prévoit une sixième section de registre (VI) au moyen de laquelle on peut régler le mode de sortie.

18. Dispositif selon la revendication 17, **caractérisé en ce qu'**un bit est inscrit ou peut être inscrit dans la sixième section de registre (VI) en fonction de sa valeur entre un premier mode de sortie dans lequel on empêche la modification d'un pointeur qui indique un endroit dans la mémoire et qui peut être modifié avant ou après l'extraction par lecture jusqu'à ce que l'état du compteur soit inférieur ou égal au nombre défini, et un deuxième mode dans lequel on permet à tout moment une modification du pointeur indépendamment de l'état du compteur.

19. Dispositif selon l'une quelconque des revendications 9 à 18, **caractérisé en ce qu'**il fait partie d'un dispositif de télécommunications portable pour la télécommunication mobile.
